# EUROPÄISCHE PATENTSCHRIFT

(11) **EP 0 829 017 B1**
(45) Veröffentlichungstag und Bekanntmachung des Hinweises auf die Patenterteilung: **03.11.1999**
(21) Anmeldenummer: 96915949.0
(22) Anmeldetag: 22.05.1996
(51) Int. Cl.: G01R 33/038, G01B 7/34

(54) **HERSTELLUNGSVERFAHREN FÜR SONDE MIT BESCHICHTETER SPITZE**
PROCESS FOR PRODUCING A PROBE WITH A COATED POINT
PROCEDE DE PRODUCTION D'UNE SONDE A POINTE POURVUE D'UN REVETEMENT

(30) Priorität: 27.05.1995 DE 19519478
(43) Veröffentlichungstag der Anmeldung: 18.03.1998
(73) Patentinhaber: FORSCHUNGSZENTRUM JÜLICH GMBH, 52425 Jülich (DE)
(72) Erfinder: SCHELTEN, Jakob, D-52428 Jülich (DE); BAUER, Patrick, D-52249 Eschweiler (DE); BOCHEM, Hans-Peter, D-52428 Jülich (DE)
(86) Internationale Anmeldenummer: DE9600893
(87) Internationale Veröffentlichungsnummer: WO9637788

(56) Entgegenhaltungen:
- EP-A- 0 483 579
- EP-A- 0 488 133
- JOURNAL OF VACUUM SCIENCE AND TECHNOLOGY: PART A, Bd. 11, Nr. 6, November 1993 - Dezember 1993, NEW YORK US, Seiten 2570-2573, XP000423410 P.B.FISCHER E.A,: "Ultrhigh resolution magnetic force mocroscope tip fabricated using electron beam lithography"
- IBM TECHNICAL DISCLOSURE BULLETIN, Bd. 35, Nr. 3, August 1992, NEW YORK US, Seiten 150-152, XP000326214 "functionalized sxm tip"
- JOURNAL OF APPLIED PHYSICS, Bd. 68, Nr. 3, August 1990, NEW YORK US, Seiten 1169-1183, XP000107909 D,RUGAR E,A,: "Magnetic force microscopy: General principles and application to longitudinal recording media"

## Beschreibung

Die Erfindung bezieht sich auf ein Verfahren zur Beschichtung der Spitze einer Meßsonde. Derartige Meßsonden eignen sich im Falle einer Beschichtung mit ferromagnetischem Material insbesondere für den Einsatz bei der magnetischen Rasterkraftmikroskopie.

Die Druckschrift "Journal of Vacuum Science & Technoloqy B 11 (1993) Nov./Dez., Nr. 6, Seiten 2570 bis 2573" offenbart ein Verfahren zur Herstellung einer lediglich an ihrem distalen Ende ferromagnetisch beschichteten Sondenspitze, bei dem eine ferromagnetische Schicht auf die Spitze aufgedampft wird. In diesem Verfahren wird eine Elektrodenstrahlinduzierte Ausscheidung benutzt, und zwar zur Herstellung eines die Sondenspitze tragenden Fortsatzes.

Die Druckschrift EP-A-0 488 133 zeigt und beschreibt ein Verfahren zur Herstellung einer ferromagnetisch beschichteten Sondenspitze, bei dem eine ferromagnetische Schicht auf die Spitze aufgebracht und dann mit einer Schutzschicht, nämlich einem Fotolack, abgedeckt wird. Die nicht mit Fotolack abgedeckte aufgedampfte ferromagnetische Schicht wird danach entfernt.

Seit zehn Jahren gibt es die von Binnig et al. (G. Binnig, C. F. Quate and C. Gerber, Phys. Rev. Lett. **56** (1986) 930) entwickelte Rasterkraftmikroskopie. Sie hat universale Bedeutung erlangt, weil mit ihr Metall - Halbleiter - und Isolator - Oberflächen im Kontaktmodus mit fast atomarer lateraler Auflösung und im Nicht - Kontaktmodus mit geringerer lateraler Auflösung untersucht werden können. Ein Übersichtsartikel über die Methode der Rasterkraftmikroskopie und die Kräfte zwischen Sonde und Probe, die damit gemessen werden können, findet sich in E. Meyer and H. Heinzelmann, SpringerSeries in Surface Sciences **28** (1992) 99.

Inzwischen sind Sonden, die aus Siliziumnitrid, aus Siliziumdioxid oder aus n - dotiertem, einkristallinem Silizium bestehen, kommerziell erhältlich (Nanosensors GmbH, Aidlingen, BRD, Park Scientific Instruments Sunnyvale, CA USA). Die beiden wesentlichen Komponenten solcher Sonden sind ein biegsamer Hebelarm und zum Ende hin eine exponierte Spitze.

Eine Spezialisierung der breit angewendeten Rasterkraftmikroskopie ist die magnetische Kraftmikroskopie, bei der magnetische Oberflächenstrukturen detektiert werden. In den ersten Arbeiten wurden mit dieser Methode Aufnahmen von magnetische Domänenwänden versucht (J. J. Saenz, N. Garcia, P. Grütter, E. Meyer, H. Heizelmann, R. Wiesendanger, L. Rosenthaler, H. R. Hidber, and H. J. Güntherrodt, J. Appl. Phys. 62 (1987) 4293; R. Allensbach, H. Salemink, A. Bischof, and E. Weibel, Z. Phys. B 67 (1987) 125). Ein weites Anwendungsfeld findet die Methode in den Materialien, die für die magnetische Datenspeicherung verwendet werden. Ein Übersichtsartikel über die Methode und Anwendungsbeispiele findet sich in P. Grütter, H. J. Mamin, and D. Rugar SpringerSeries in Surface Sciences **28** (1992) 99.

Für die Herstellung der magnetischen Sonden, die aus einer scharfen magnetischen Spitze und aus einem elastisch biegsamen Hebelarm bestehen, wurden verschiedene Verfahren erprobt. Eine weit verbreitete Methode ist das elektrochemische Ätzen von ferromagnetischen Folien oder Drähten aus Nickel, Nickel/Eisen - Legierungen oder Kobalt. Häufig werden unmagnetische Sonden, die für die konventionelle Rasterkraftmikroskopie hergestellt wurden, großflächig mit ferromagnetischen Filmen beschichtet. So wurden Wolfram -Sonden durch Sputterdeposition mit CoPtCr, Fe und CoZrNb beschichtet und Sonden aus Si₃N₄ oder einkristallinem Silizium mit Ni, NiFe und Co bedampft.

Beiden Verfahren ist gemeinsam, daß nicht nur das vorderste Ende der Spitze ferromagnetisch wird, sondern daß auch der Rest der Spitze und der ganze biegsame Hebelarm magnetisch werden. Deshalb entstehen in unübersichtlicher Weise magnetische Kräfte zwischen Probe und Hebelarm, die in Summe gemessen werden und erheblich die laterale Auflösung beeinträchtigen.

Es wurde bereits versucht, diese globale Magnetisierung zu vermeiden, indem auf die Spitze eines geätzten Wolframdrahts eine ferromagnetische Kugel aus Nickel gesetzt wurde. Hierfür wurde im Rasterelektronenmikroskop eine Elektroschweißung zwischen Wolframspitze und dünner Nickelfolie vorgenommen (H. Lemke, T. Göddenhenrich, H. P. Bochem, U. Hartmann, C. Heiden, Rev. Sci. Instrum. 61 (1990) 2538). Die durch Elektroschweißen erzeugten Ferromagnete wiesen jedoch nachteilig zu große Durchmesser (in der Größenordnung von µm) auf (siehe auch P. Grütter, H. J. Mamin, and D. Rugar SpringerSeries in Surface Sciences **28** (1992) 99).

Aufgabe der Erfindung ist die Schaffung eines Verfahrens zur Herstellung von Sonden für die magnetische Rasterkraftmikroskopie, die sehr kleine ferromagnetische Spitzen aufweisen.

Die Aufgabe wird durch eine Verfahren mit den Merkmalen des Hauptanspruchs gelöst.

Unter ferromagnetischer Beschichtung ist zu verstehen, daß die Schicht ferromagnetische Eigenschaften aufweist. Diese Beschichtung auf der Spitze weist eine laterale Ausdehnung von 20 bis 100 nm auf. Vorteilhaft beträgt die laterale Ausdehnung der Schicht mehr als 50 nm, insbesondere wenn die Sonde bei der magnetischen Rasterkraftmikroskopie eingesetzt werden soll. Die Schichtdicke beträgt dann ebenfalls vorteilhaft einige 10 bis einige 100 nm, um den gewünschten magnetischen Effekt zu bewirken. Die Spitze kann sowohl mit weichals auch mit hartmagnetischen Materialien beschichtet sein.

Das Herstellungsverfahren für eine derartige Vorrichtung weist folgende Merkmale auf.
1.Beschichtung der Sonde mit einem ferromagnetischen Material (z. B. Nickel oder Eisen), beispielsweise durch Bedampfung, Sputterdeposition, Laser-Ablation, Plasma - Deposition oder chemische Gasphasenabscheidung. Die Beschichtung erfolgt zwecks Vereinfachung des Verfahrens vorteilhaft großflächig.
2.Herstellung einer Schutzschicht mittels Elektronenstrahl auf der Spitze. Der positionierbare Elektronenstrahl in einem Rasterelektronenmikroskop ist hierfür besonders geeignet. Infolge des stets unvermeidlich vorhandenen Restgases (hier im Mikroskop) entsteht eine Kohlenstoffabscheidung auf der beschichteten Spitze, induziert durch den Elektronenstrahl.
   Vorteilhaft kann dabei die Elektronenstrahl - induzierte Abscheidung durch Zufuhr kohlenstoffhaltiger Gase beschleunigt werden.
3.Entfernung des ungeschützten Teils der Beschichtung, z. B. durch großflächige Ionenstrahl-Sputter-, Plasma- oder naßchemische Ätzung. Die Kohlenstoffabscheidung schützt die ferromagnetische Schicht vor ihrer Abtragung. Vorteilhaft wird ferner eine Überätzung durchgeführt, um den eventuell noch vorhandenen Rest - Kohlenstoff zu beseitigen.

Die Lineardimensionen des derart veredelten ferromagnetischen Bereiches werden durch die gewählte Dicke der ferromagnetischen Schicht und durch die Ausdehnung (laterale Ausdehnung) des auf die Spitze gerichteten Strahls bestimmt. In beiden Fällen sind 20 nm Dimensionen einstellbar.

Die Veredelungsschicht ist quasi über die Spitze gestülpt und daher fest mit der Spitze verbunden. Reinigungsverfahren vor der Beschichtung oder Haftvermittler verbessern weiter die Haftung der Veredelungsschicht auf der Spitze.

An die Materialien von Beschichtungsgut und Sonde werden keine speziellen Forderungen gestellt. Die ferromagnetische Eigenschaft ist lediglich für die spätere Anwendung als Meßsonde von Bedeutung.

Das Herstellungsverfahren kann kostengünstig durchgeführt werden.
Es zeigen:

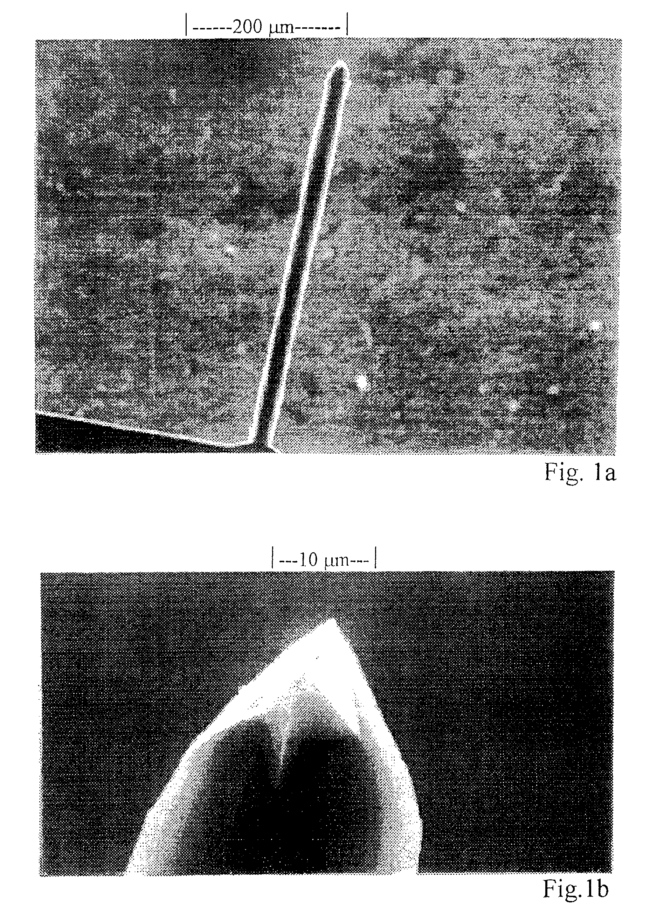

Fig. 1 a) Rasterelektronenmikroskop - Aufnahme einer Silizium - Sonde mit Hebelarm und Silizium - Spitze.
Fig. 1 b) Vergrößerte Aufnahme des hinteren Teils des Hebelarms mit aufgesetzter Spitze.
Fig. 2) Rasterelektronenmikroskop - Aufnahme der Silizium - Spitze nach Nickel-Bedampfung mit einer Schichtdicke von einigen nm und Kohlenstoffdeposition.
Fig. 3) EDX - Aufnahme der Sonde nach Ionenstrahlätzung
   a) im Spitzen - Bereich mit dem Auftreten des Nickel - Peaks und
   b) auf dem Hebelarm , wo kein Ni mehr nachweisbar ist.

Für die Erprobung der magnetischen Veredelung wurden kommerziell erhältliche Sonden aus einkristallinem Silizium verwendet. Der wesentliche Teil der Sonde besteht aus einem 200 µm langen etwa 20 µm breiten und einige µm dicken Hebelarm, an deren Ende sich eine etwa 5 µm hohe Si - Spitze befindet (siehe Fig. 1 a und b). Die Sonden wurden auf ihrer Spitzenseite durch Elektronenstrahlverdampfung mit Nickel beschichtet. Typische Schichtdicken waren 20 nm.

Die beschichteten Sonden wurden in ein hochauflösendes Rasterelektronenmikroskop eingeschleust. Mit der üblichen Abbildungstechnik wurde auf die Spitze einer Sonde scharf gestellt und anschließend wurde der Strahl auf die Spitze fixiert. Typische Bestrahlungsbedingungen waren: Strahlstrom 20 pA, Strahldurchmesser 10 nm, Bestrahlungsdauer 5 min, Restgasdruck 8^{*}10⁻⁶ mb.

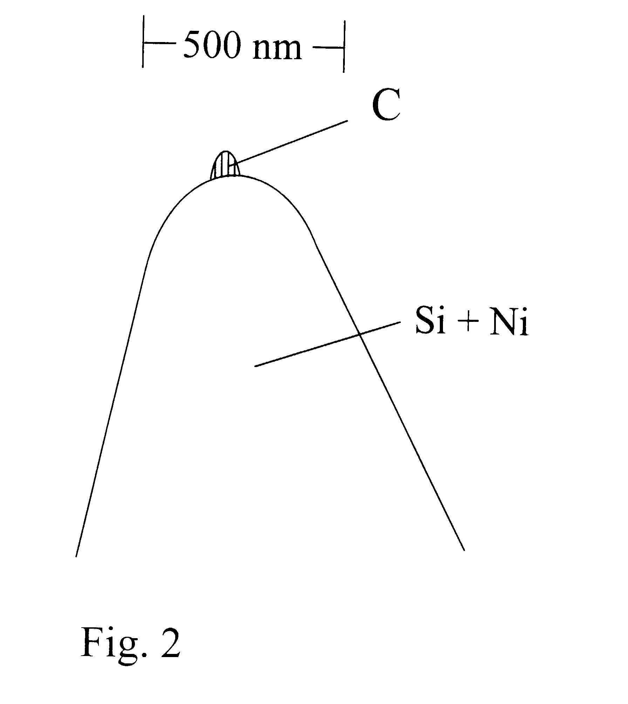

Nach der Kohlenstoffablagerung, die im wiedereingeschalteten Abbildungsmodus beobachtbar ist (Fig. 2), erfolgte eine Ionenstrahlätzung mit einem großflächigen Ar⁺ - Ionenstrahl von 500 eV Strahlenergie und einer Stromdichte von 0.5 mA cm⁻². Die Sputterraten von Kohlenstoff sind fünf - mal niedriger als die von Nickel. Deshalb reichen dünne Kohlenstoffschichten aus, um beim Sputterätzen schützend zu wirken. Typische Ätzzeiten waren 6 min.

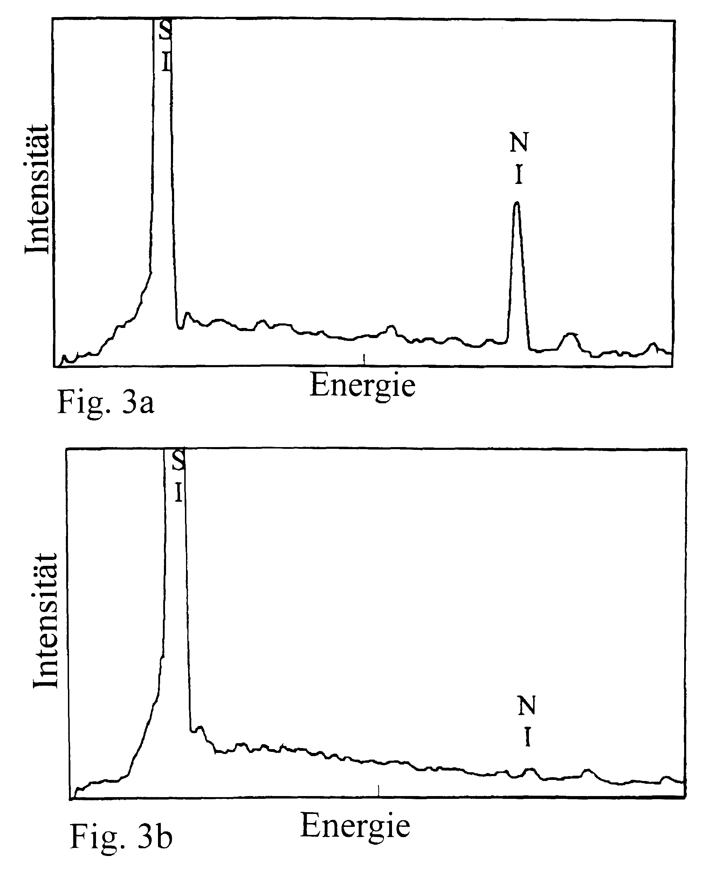

EDX - Aufnahmen von solchen geätzten Sonden zeigen, daß Nickel nur noch an der Spitze zu finden ist ( Fig. 3 a und b). Bei EDX-Aufnahmen wird Elektronenstrahl-induzierte Röntgen - Intensität gegen die Röntgenenergie aufgetragen.

Durch Einbau solcher magnetisch veredelter Spitzen in ein Rasterkraftmikroskop konnte nachgewiesen werden, daß der vorhandene Ni - Bereich ferromagnetisch ist.

## Patentansprüche

1. Verfahren zur Herstellung einer ferromagnetischen Schicht an dem distalen Ende einer Sondenspitze mit folgenden Schritten
- Aufbringung einer ferromagnetischen Schicht auf die Spitze,
- Elektronenstrahl - induzierte Abscheidung einer Schutzschicht auf der Spitze,
- Entfernung der aufgebrachten, nicht mit Schutzschicht bedeckten ferromagnetischen Schicht.

## Claims

1. Process for producing a ferromagnetic layer on the distal end of a probe tip, comprising the following steps:
- application of a ferromagnetic layer to the tip,
- electron-beam-induced deposition of a protective layer on the tip,
- removal of the applied ferromagnetic layer not covered by the protective layer.

## Revendications

1. Procédé de production d'une couche ferromagnétique à l'extrémité distale d'une pointe de sonde comprenant les stades suivants:
- dépôt d'une couche ferromagnétique sur la pointe,
- dépôt induit par faisceau d'électrons d'une couche de protection sur la pointe,
- élimination de la couche ferromagnétique déposée non recouverte de la couche de protection.
